**Europäisches Patentamt**

**European Patent Office**

**Office européen des brevets**

(19)

(11) Publication number: **0 178 654**
A2

(12) # EUROPEAN PATENT APPLICATION

(21) Application number: **85113140.9**

(22) Date of filing: **16.10.85**

(51) Int. Cl.⁴: **H 01 L 21/312**
**H 01 L 21/31, G 03 F 7/02**

(30) Priority: **17.10.84 JP 216443/84**

(43) Date of publication of application:
**23.04.86 Bulletin 86/17**

(84) Designated Contracting States:
**DE FR GB**

(71) Applicant: **Kabushiki Kaisha Toshiba
72, Horikawa-cho Saiwai-ku
Kawasaki-shi Kanagawa-ken 210(JP)**

(72) Inventor: **Atsumi, Tsuneo c/o Patent Division
KABUSHIKI KAISHA TOSHIBA 1-1 Shibaura 1-chome
Minato-ku Tokyo 105(JP)**

(72) Inventor: **Hiraki, Shunichi c/o Patent Division
KABUSHIKI KAISHA TOSHIBA 1-1 Shibaura 1-chome
Minato-ku Tokyo 105(JP)**

(74) Representative: **Henkel, Feiler, Hänzel & Partner
Möhlstrasse 37
D-8000 München 80(DE)**

(54) Method of manufacturing a semiconductor device comprising a method of patterning an organic material.

(57) Disclosed is a method of manufacturing a semiconductor device comprising the step of forming an organic material film on the surface of a semiconductor substrate, and the step of irradiating an excimer laser beam onto the organic material film in an atmosphere containing oxygen gas so as to scan in accordance with a specified pattern, thus removing an irradiated portion of the organic material film to thereby form an organic material pattern. The organic material pattern is directly formed without need of a developing step.

EP 0 178 654 A2

TITLE MODIFIED
see front page

- 1 -

Method of manufacturing a semiconductor device

The present invention relates to a method of manufacturing a semiconductor device, and, more particularly, to a method of patterning an organic material film without using photolithography or electron beam lithography.

In the known process of manufacturing a semiconductor device, the formation of a pattern is made with the use of photolithography including a light exposure step, or electron beam lithography including an electron beam exposure step. This lithography necessitates, in advance of performing the light or electron-beam exposure step, carrying out the pretreating and prebaking step for improving the coherence of a resist film to the substrate. It also necessitates, after the exposure step, carrying out a developing step, washing (fixing) step, and a post-baking step.

As will be understood from the above, the conventional patterning method includes a large number of steps. This has been an obstacle to increasing production efficiency and reducing the manufacturing cost of the semiconductor device.

In the conventional patterning method, the precision is greatly affected by the material of which the resist is made, so that it is necessary to use resist which has been prepared on a special basis. Further, the exposure step necessitates the use of much expensive equipment, including a mask aligner, electron beam delineating apparatus, etc., also an impediment in reducing the manufacturing cost of the semiconductor device.

In view of the above, the object of the invention is to provide a method of manufacturing a semiconductor device involving the use of a novel patterning method and facilitating a large increase in production efficiency as well as a significant reduction in the manufacturing cost of the semiconductor device.

The method of manufacturing a semiconductor device in accordance with the invention includes the steps of forming an organic material film on the surface of a semiconductor substrate, and of irradiating an excimer laser beam onto the organic material film in an atmosphere containing oxygen gas so as to scan in accordance with a specified pattern; thus removing an irradiated portion of the organic material film to thereby form an organic material pattern.

The semiconductor device used in the method according to the invention is not limited to a substrate of silicon, GaAs or the like, but includes any one of the structures wherein various layers including an oxide layer, a nitride layer, a metal layer, etc., are formed on said substrate.

The quality of the material constituting the organic material film can be selected according to the purpose to which the obtained organic material pattern will be put. If the organic material pattern is used as an etching mask, a material of high etching resistivity must be selected. If the organic material pattern is used as an insulating film, then a material of good insulating property must be selected.

Thermosetting resin which includes, for example, polyimide resin, silicone resin, epoxy resin, etc., is preferable as the material of the organic material film. Further, the various resist materials which are usually used in the photolithography or electron beam lithography can also be used.

When an excimer laser beam (wavelength: 100 to 300 nm) is irradiated onto an organic material film in an atmosphere containing oxygen gas, oxygen radicals and ozone are produced in the atmosphere, and the oxidation of the organic material film is promoted. As a result, the portion of the organic material film which has been irradiated with the laser beam is selectively or locally ashed to obtain an organic material pattern. This invention is based on the utilization of this phenomenon.

The organic material pattern thus obtained can be used as an etching mask for selectively etching an oxide film or the like, or, it can be used as an insulating film by being left on the substrate as it stands.

Since the use of the method of the invention makes it possible to form an organic material pattern simply by scanning laser beams without the execution of, for example, a developing step, it is possible not only to greatly reduce the manufacturing cost but also to considerably increase the production efficiency of the semiconductor device.

The invention will be more fully understood from the Examples which follow.

Example 1

A polyimide film is uniformly coated as an organic material film on the surface of a silicon substrate, to a thickness of 1 to 2 $\mu$m, and the resultant substrate is thermoset at a temperature of 200 to 450°C. The resultant semiconductor substrate is received in a vacuum chamber whose internal pressure is then lowered to $10^{-6}$ torr. Thereafter, oxygen gas is introduced into the vacuum chamber to keep the chamber under a pressure of 1 torr or less. In this state, the surface of the polyimide film is scanned by an excimer laser beam under the control of a computer, and the polyimide film is burned away in accordance with a specified

- 4 -

0178654

circuit pattern (i.e. the laser-beam scanned portions of the film are ashed). Thus, an organic material pattern which has a specified circuit pattern is formed on the substrate. Subsequently, a semiconductor device is manufactured through carrying out predetermined steps using this organic material pattern as a field isolation film.

Further, it is possible to manufacture a semiconductor device equipped with an interlayer insulator consisting of the organic material pattern.

Example 2

A positive resist is uniformly coated to a thickness of 1.5 μm on a silicon semiconductor with an oxide film formed on its surface, and the resist film is thermoset at a temperature of 120°C. The resultant semiconductor substrate is received within a vacuum chamber, whose internal pressure is then lowered to $10^{-6}$ torr. Thereafter, oxygen gas is introduced into the vacuum chamber and this vacuum chamber is kept at a pressure level of 1 torr or less. In this state, the surface of the organic material film is scanned by an excimer laser beam and this film is burned away in conformity with a specified circuit pattern to obtain an organic material film pattern. By using this organic material film pattern as a mask, the oxide film located beneath the same is etched, and thereafter the organic material film is removed to obtain an oxide film pattern. Thus, a semiconductor device is obtained by imparting, for example, a wiring onto the oxide film pattern. Therefore, according to this Example, the organic material film need not be an insulation film because it only serves as a resist as in the prior art.

As will be apparent from the foregoing description, the method of the invention eliminates the necessity of using materials intended for use as a mask, a developing agent, a washing (fixing) agent, etc. In addition, it also eliminates the necessity of using equipment including a mask aligning type exposure device, a developing apparatus, etc. In addition, the process of manufacturing does not include the developing and washing steps. Thus, it becomes possible not only to greatly reduce the manufacturing cost of the semiconductor device, but also to reduce the number of manufacturing steps to thereby increase not only the production efficiency but also the manufacturing yield of the semiconductor device.

0178654

- 1 -

Claims:

1.   A method of manufacturing a semiconductor device comprising the step of forming an organic material film on the surface of a semiconductor substrate, and the step of irradiating an excimer laser beam onto said organic material film in an atmosphere containing oxygen gas so as to scan in accordance with a specified pattern; thus removing an irradiated portion of said organic material film to thereby form an organic material pattern.

2.   A method of manufacturing a semiconductor device as set forth in claim 1, characterized in that said organic material film is formed of a material selected from the group consisting of polyimide resin, silicon resin, epoxy resin and resist.

3.   A method of manufacturing a semiconductor device as set forth in claim 1, characterized in that said organic material pattern is used as a field isolation film.

4.   A method of manufacturing a semiconductor device as set forth in claim 1, characterized in that said organic material pattern is used as an interlayer insulator.

5.   A method of manufacturing a semiconductor device as set forth in claim 1, characterized in that said organic material pattern is used as an etching mask.